Europäisches Patentamt

**European Patent Office**

Office européen des brevets

(19)

(11) Publication number: **0 027 903**
**B1**

(12) **EUROPEAN PATENT SPECIFICATION**

(45) Date of publication of patent specification: **14.09.83**

(21) Application number: **80105797.7**

(22) Date of filing: **25.09.80**

(51) Int. Cl.³: **H 01 L 21/285,**
**H 01 L 29/80**

(54) Method of fabricating a GaAs semiconductor Schottky barrier device.

(30) Priority: **26.10.79 US 88718**

(43) Date of publication of application:
**06.05.81 Bulletin 81/18**

(45) Publication of the grant of the patent:
**14.09.83 Bulletin 83/37**

(84) Designated Contracting States:
**DE FR GB IT**

(56) References cited:
**EP - A - 0 016 968**
**FR - A - 2 098 314**
**FR - A - 2 211 757**
**FR - A - 2 387 514**
**US - A - 4 075 652**
**US - A - 4 077 111**

**IBM TECHNICAL DISCLOSURE BULLETIN, vol.
14, no. 4, September 1971, pages 1248—1249
New York, U.S.A. W. P. DUMKE et al.: "GaAs
field effect transistors with self-registered
gates"**

(73) Proprietor: **International Business Machines
Corporation**
**Old Orchard Road**
**Armonk, N.Y. 10504 (US)**

(72) Inventor: **Hovel, Harold John**
**Diane Court**
**Katonah New York 10598 (US)**
Inventor: **Woodall, Jerry McPherson**
**36 Cherry Street**
**Bedford Hills New York 10507 (US)**

(74) Representative: **Lancaster, James Donald**
**IBM United Kingdom Patent Operations Hursley
Park**
**Winchester Hants S021 2JN (GB)**

(56) References cited:
**SOLID STATE ELECTRONICS, vol. 13, April
1970, pages 485—489 London, G.B. G. O.
LADD et al.: "GaAs Schottky barrier diodes by
the fluid wetting of tin and indium"**

Courier Press, Leamington Spa, England.

Method of fabricating a GaAs semiconductor Schottky barrier device

The invention relates to a method of fabricating a semiconductor Schottky barrier device. In such fabrication processes, the small dimensions, and the precision with which those dimensions must be held, are reaching the point where the physical properties of the materials and processes involved must be very carefully selected. Dimensions of less than a micron are under consideration at the present state of the art.

One structure for which small dimensions can be desirable to achieve low power and low signal delays is the gallium arsenide metal semiconductor field effect transistor (MESFET) However there are difficulties in constructing these devices in dimensionally small form. One difficulty is that during processing impurities may outdiffuse from the semi-insulating substrate into the channel layer and adversely affect its characteristics. To overcome this a buffer layer of GaAs material could be grown on the semi-insulating substrate followed by growth of the channel layer. Another difficulty is in achieving a Schottky barrier height greater than 0.9eV to avoid significant leakage current between gate and drain. A third difficulty is in achieving a gate width of a micron or less, for which a "self-alignment" fabrication procedure should be expected.

"IBM Technical Disclosure Bulletin" Vol. 14, September 1971 pages 1248—1249 discloses a method according to the preamble of claim 1, and more particularly a MESFET. The making of Schottky barrier diodes on GaAs by melting metal spheres onto the surface near their melting point is disclosed in "Solid-State Electronics", Vol. 13, April 1970, pages 485—489.

Reference is also made to US Patent 4,075,652 which discloses a method of fabricating a pn semi-conductor junction. The pn junction is between the gate region and channel region of a GaAs field effect transistor, and may be 1 micron wide. A p-type GaAlAs gate region layer, which is on top of an n-type GaAlAs channel layer, is selectively etched to form the pn junction of narrow width. Aluminium is applied by a single vacuum deposition step to the exposed region of the channel layer and to a cap on the remaining region of the gate region layer, so that drain and source electrodes are formed for the FET on opposite sides of, and self-aligned with, a gate electrode. The cap material is chemically substantially the same as the channel layer i.e. $GA_{1-k}Al_kAs$, where $0.1 \geq k \geq 0$, although of opposite conductivity type.

In the drawings:—

Fig. 1 is a schematic of a general process of steps of the invention;

Fig. 2 is a schematic of steps of a particular embodiment; and

Fig. 3 is a band energy diagram.

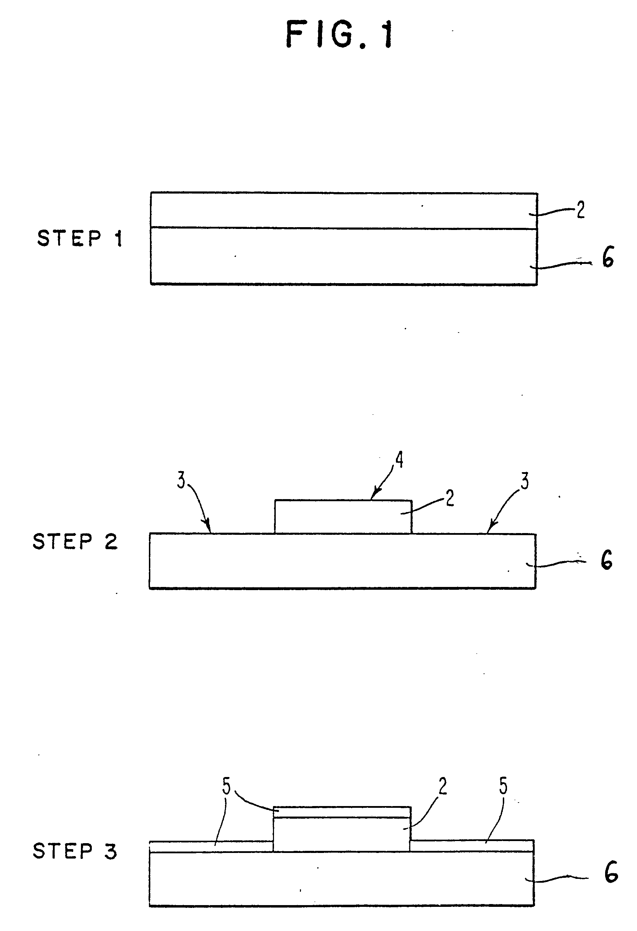

As regards the process of Fig. 1 step 1 shows a semiconductor substrate 6 of a doped semiconductor material which is provided with a thin epitaxial layer 2 of different semiconductor material. The two materials are respectively n-type GaAs for the substrate 1 and n-type GaAlAs for the epitaxial layer 2. The two materials are selected such that a metal used in step 3 will have a different solubility in layer 6 than it will have in layer 2.

Referring to step 2, a vertical differentiation is now provided to delineate areas where the difference in solubility is to be employed. This is done, for example, by etching away portions of the layer 2, leaving exposed, regions 3 of the substrate and region 4 of the epitaxial layer 2.

Referring to step 3, a metal 5 is then deposited on the regions 3 and 4, and is fused thereto. The metal 5, when fused, alloys with the substrate 6 and forms ohmic contacts on opposite sides of region 4, but it will not alloy with the region 4, but it forms a Schottky barrier type rectifying contact with the region 4. The resulting structure after the single temperature step is a field effect transistor structure wherein the two ohmic contacts serve as the source and the drain contacts and the Schottky barrier contact serves as the gate contact.

The invention relates to a gallium arsenide substrate having a thin epitaxial layer of gallium aluminum arsenide thereover. Such a structure when processed in accordance with the teachings of the invention, can result in a high gate barrier FET transistor.

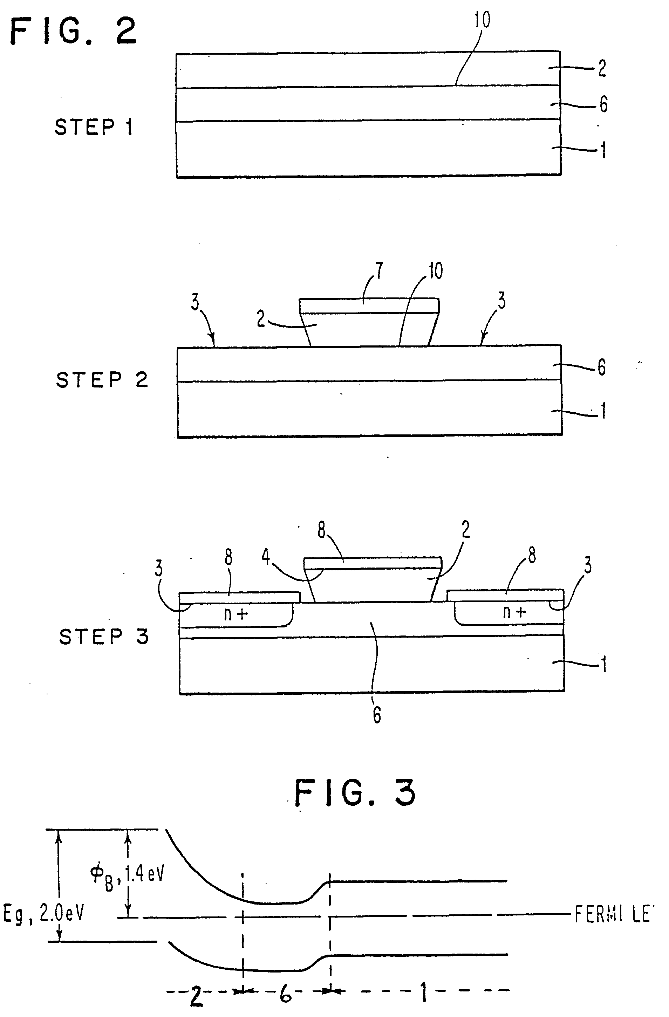

Thus referring to Fig. 2, step 1 shows a semi-insulating gallium arsenide substrate 1 doped with chromium (i.e. so that it is p-type), provided with an epitaxial layer 2 of gallium aluminum arsenide, and a GaAs channel layer 6.

As an example of one way to produce this structure, the substrate 1 is soaked in an isothermal two-phase equilibrium liquid phase epitaxy melt for 15 to 30 minutes. The melt contains a conductivity type determining element such as tin, sulfur, tellurium, or another common donor dopant element. Liquid phase epitaxy is used to produce the gallium aluminum arsenide layer 2, and during this epitaxial growth unwanted impurities are gettered into the melt from the upper region of the chromium doped gallium arsenide, and simultaneously the donor dopant element diffuses into the substrate 1 of gallium arsenide and produces the n-type channel layer 6. The epitaxy technique may cause the epitaxial layer 2 to be graded in composition and in energy band-gap. The epitaxy technique described can be replaced by that described in US Patent 4122476.

The structure illustrated in Fig. 2 in step 1 may be more clearly perceived by referring simultaneously to Fig. 3.

As a result of the epitaxial growth, there is a 0.05 to 0.1 micron gallium aluminum arsenide layer 2 which, as may be gathered from Fig. 3, is graded in composition and energy band-gap, the band-gap being approximately 2.0eV. When a Schottky barrier is made to this layer 2 a barrier height of 1.4eV is obtained which greatly reduces the gate-drain current. A graded composition layer is more desirable than a uniform composition one of 2.0eV band-gap to avoid jumps in the energy bands at the interface 10 between the two semiconductor materials 2, 6. The diffused GaAs layer 6 is about 0.3 microns thick and has about $10^{17}$ impurity atoms/cc.

The layer 6 shown in Fig. 2 and as described above is a diffused region in which the dopant has diffused into the GaAs in accordance with the diffusion coefficient. However, as an alternative the layer 6 may be produced in the lower surface region of the graded epitaxial layer 2, since this lower surface region is almost pure gallium arsenide, or as still another alternative, the doped gallium arsenide layer 6 may be epitaxially grown before the gallium aluminum arsenide layer 2 is grown.

Referring next to step 2 of Fig. 2, an area of photoresist 7 is formed over a portion of the gallium aluminum arsenide layer 2 and this layer is then selectively etched with HCl acid, exposing the regions 3, and undercutting region 2 at its side walls.

Referring now to step 3 of Fig. 2, a layer 8 of tin is provided in a single step selectively on the regions 3 and over the region 4 which has been exposed when the photoresist 7 is removed. The metal layer 8 may be made up of tin with a layer of tungsten on top. The structure is fused by heating to 400—600° at which point the tin will dissolve some gallium arsenide of region 3 but will not significantly dissolve gallium aluminum arsenide of region 4, due to the different solubilities of these material in tin. When the structure is cooled down, the result is two n+ regions each with $2 \times 10^{18}$ doping atoms/cc, in the gallium arsenide channel layer 6, and each of which forms as an epitaxial layer that grows from the dissolved tin-gallium arsenide melt. The tungsten would help to keep the tin in layer form and to prevent it from balling up during the liquid phase epitaxial growth. The metal layer 8 forms ohmic contacts to the layer 6 by means of the heavily doped n+ regions 3.

On the region 4, however, the tin does not significantly dissolve the gallium aluminum arsenide but rather it remains inert and forms a Schottky barrier contact, intermediate the ohmic contacts.

The resulting structure is a particularly advantageous gallium arsenide metal semi-conductor FET structure (MESFET). The structure has a number of advantages. The excess impurities have been gettered during the processing operation. There is simultaneous formation of the Schottky barrier and the ohmic contacts. The gate and source-drain regions are self-aligned. The same metallurgy is employed for all contacts and a high barrier height of 1.4eV is provided for the gate of the FET. The invention can also be applied to producing a simple Schottky barrier having one contact to region 4 and only one of the n+ ohmic contacts.

## Claims

1. A method of fabricating a GaAs semiconductor Schottky barrier device with self-registered first and second contacts, the first contact being the one at which the Schottky barrier is formed, from a semi-conductor body having strata comprising a first n-type GaAlAs layer (2) and a second underlying n-type GaAs layer (6) the first layer being selectively etched, to leave a remaining region (4) of the first layer and to expose a region (3) of the second underlying layer, a metal (5, 8) being simultaneously applied to said remaining region (4) and to said exposed region (3) the metal differently affecting the semiconductor of the first and second layer so that said Schottky barrier is formed in said body at said first contact, whereas said second contact is ohmic, characterised in that, after said metal is applied, it is fused so that, due to the different solubility of said first and second layers in, or reactivity with said metal during said fusing an n+GaAs region is formed from part of said second underlying layer at said exposed region, which part has been diffused by said metal of said second contact during said fusing, and said first contact is formed to said remaining region (4).

2. A method as claimed in claim 1, applied to fabricating a MESFET, the first contact being the gate contact of the MESFET, and being intermediate said second contact and a third contact which forms ohmic source and drain contacts of the MESFET, there being two of said n+ GaAs regions formed in said second layer by said fusing, which two regions are contacted by said source and drain contacts, and are the source and drain regions of the MESFET.

3. A method as claimed in claim 1 or 2 in which said first layer has a depth of 0.05 to 0.1 micrometers.

4. A method as claimed in any preceding claim in which the first layer has a larger energy gap than the n-type GaAs of the second layer.

5. A method as claimed in claim 4 in which the composition of the first layer is graded so that its energy gap varies from a value, adjacent said second layer, corresponding to that of the n-type GaAs of the second layer, to a larger energy gap of 2 electron volts adjacent the Schottky barrier.

## Patentansprüche

1. Verfahren zur Herstellung eines GaAs-Halbleiter-Schottky-Elementes mit selbstausrichtendem erstem und zweitem Kontakt, wobei die Schottky-Barriere am ersten Kontakt ausgebildet wird, aus einem Halbleiter mit einer ersten n-leitenden Schicht aus GaAlAs (2) und einer zweiten darunterliegenden ebenfalls n-leitenden Schicht aus GaAs (6), wobei die erste Schicht selektiv so geätzt wird, daß ein Restteil (4) der ersten Schicht übrigbleibt und ein Teil (3) der darunterleigenden zweiten Schicht freigelegt wird und ein Metall (5, 8) gleichzeitig auf den Restteil (4) und den freigelegten Teil (3) aufgebracht wird, wobei das Metall den Halbleiter der ersten und zweiten Schicht unterschiedlich beeinflußt, so daß die Schottky-Barriere in besagtem Körper an dem ersten Kontakt gebildet wird, während der genannte zweite Kontakt ein Ohm'scher Kontakt ist, dadurch gekennzeichnet, daß nach Aufbringen des Metalles dieses geschmolzen wird, so daß aufgrund der unterschiedlichen Löslichkeit besagter erster und zweiter Schicht in Reaktivität mit besagtem Metall während der Schmelzung ein n+ GaAs-Bereich aus einem Teil der genannten darunterliegenden zweiten Schicht in dem genannten freigelegten Bereich gebildet wird, der durch das Metall des genannten zweiten Kontaktes während der Schmelzung diffundiert, und besagter erster Kontakt an dem genannten Restbereich (4) gebildet wird.

2. Verfahren nach Anspruch 1, angewendet auf die Herstellung eines MESFET, wobei der erste Kontakt der Gate-Kontakt des MESFET ist und zwischen dem genannten zweiten Kontakt und einem dritten Kontakt liegt, die den Ohm'schen Source- und Drain-Kontakt des MESFET bilden, wobei durch die Schmelzung zwei der genannten n+ GaAs-Bereiche in der genannten zweiten Schicht gebildet werden, die durch die Source- und Drain-Kontakte kontaktiert werden und die Source- und Drain-Bereiche des MESFET bilden.

3. Verfahren nach Anspruch 1 oder 2, in dem die genannte erste Schicht eine Tiefe von 0,05 bis 0,1 Mikrometer hat.

4. Verfahren nach einem der vorhergehenden Ansprüche, in dem die erste Schicht einen größeren Bandabstand hat als die zweite n-leitende GaAs Schicht.

5. Verfahren nach Anspruch 4, in dem die Zusammensetzung der ersten Schicht so abgestuft ist, daß sich der Bandabstand in der Nähe der genannten zweiten Schicht von einem Wert entsprechend dem Bandabstand der zweiten n-leitenden GaAs Schicht bis zu einem größeren Bandabstand von 2 Elektronenvolt in der Nähe der Schottky-Barriere ändert.

**Revendications**

1. Un procédé de fabrication d'un dispositif à barrière de Schottky sur un semi-conducteur en GaAs avec des premier et deuxième contacts auto-alignés, le premier contact étant celui où la barrière de Schottky est formée, à partir d'un corps semi-conducteur multicouches comprenant une première couche de GaAlAs du type n (2) et une deuxième couche sous-jacente de GaAs du type n (6), la première couche étant sélectivement décapée pour laisser une région (4) non décapée de la première couche et pour exposer une région (3) de la deuxième couche sous-jacente, un métal (5, 8) étant simultanément appliqué à ladite région non décapée (4) et à ladite région exposée (3), le métal affectant différemment le semi-conducteur des première et deuxième couches si bien que ladite barrière de Schottky est formée dans ledit corps à l'emplacement dudit premier contact tandis que ledit second contact est ohmique, caractérisé en ce que, après l'application dudit métal celui-ci est amené en fusion si bien qu'en raison des solubilités différentes desdites première et deuxième couches dans ledit métal ou de leur réactivité avec celui-ci pendant ladite fusion, une région de GaAs n+ est formée à partir d'une partie de ladite deuxième couche sous-jacente à l'emplacement de ladite région exposée, laquelle partie a été diffusée par ledit métal dudit deuxième contact pendant ladite fusion, et en ce que ledit premier contact est formé à ladite région non décapée (4).

2. Un procédé selon la revendication 1 appliqué à la fabrication d'un MESFET, le premier contact étant le contact de porte du MESFET et qu'il est situé entre ledit deuxième contact et un troisième contact, ce qui forme les contacts ohmiques source et drain du MESFET, deux desdites régions de GaAs n+ étant formées dans ladite deuxième couche par ladite fusion, ces deux régions sont contactées par lesdits contacts source et drain et constituent les régions source et drain du MESFET.

3. Un procédé selon la revendication 1 ou 2 dans lequel ladite première couche a une profondeur comprise entre 0,05 et 0,1 micron.

4. Un procédé selon l'une quelconque des revendications précédentes dans lequel la première couche a un intervalle de bande d'énergie plus large que celui du GaAs du type n de la deuxième couche.

5. Un procédé selon la revendication 4 dans lequel la composition de la première couche est graduée de façon que son intervalle de bande d'énergie varie d'une valeur dans la région adjacente à ladite deuxième couche, correspondant à celle du GaAs du type n- de la deuxième couche, à un intervalle de bande d'énergie supérieur de 2 électron volts dans une région adjacente à la barrière de Schottky.

0 027 903

FIG. 1

STEP 1

STEP 2

STEP 3

1

# FIG. 2

STEP 1

STEP 2

STEP 3

# FIG. 3

$\phi_B$, 1.4 eV

Eg, 2.0 eV

FERMI LE

--2-- --6-- ---- 1 ----

2